Europäisches Patentamt

European Patent Office

Office européen des brevets

(11) Numéro de publication : **0 432 045 B1**

(12) **FASCICULE DE BREVET EUROPEEN**

(45) Date de publication du fascicule du brevet :
06.04.94 Bulletin 94/14

(51) Int. Cl.⁵ : **H03F 1/04,** H04N 5/38,
H04N 5/14

(21) Numéro de dépôt : **90403471.7**

(22) Date de dépôt : **06.12.90**

(54) **Tube à grille à rendement amélioré.**

(30) Priorité : **08.12.89 FR 8916266**

(43) Date de publication de la demande :
**12.06.91 Bulletin 91/24**

(45) Mention de la délivrance du brevet :
**06.04.94 Bulletin 94/14**

(84) Etats contractants désignés :
**AT CH DE ES FR GB IT LI NL SE**

(56) Documents cités :
**DE-C- 747 334
GB-A- 444 050
US-A- 2 500 831
US-A- 2 881 394
PATENT ABSTRACTS OF JAPAN vol. 7, no.
222 (E-201)(1367) 04 septembre 1983, &
JP-A-58 114510 (NIPPON GAKKI SEIZO K.K.)
07 juillet 1983,
PATENT ABSTRACTS OF JAPAN vol. 6, no.
144 (E-122)(1022) 03 août 1982, & JP-A-57
67381 (TOKYO SHIBAURA DENKI K.K.) 23 avril
1982,**

(73) Titulaire : **THOMSON TUBES
ELECTRONIQUES
38, rue Vauthier
F-92100 Boulogne-Billancourt (FR)**

(72) Inventeur : **Grolleau, Claude
Thomson-CSF, SCPI, Cedex 67
F-92045 - Paris La Defense (FR)**
Inventeur : **Peillex-Delphe, Guy
Thomson-CSF, SCPI, Cedex 67
F-92045 - Paris La Defense (FR)**
Inventeur : **Gerlach, Pierre
Thomson-CSF, SCPI, Cedex 67
F-92045 - Paris La Defense (FR)**

(74) Mandataire : **Guérin, Michel et al
THOMSON-CSF SCPI B.P. 329 50, rue
Jean-Pierre Timbaud
F-92402 Courbevoie Cédex (FR)**

## Description

La présente invention concerne les tubes à au moins une grille, utilisés comme amplificateurs et qui produisent des signaux dont l'amplitude varie de façon importante. Elle vise à améliorer leur rendement.

Elle concerne plus particulièrement les tubes pour émetteurs de télévision travaillant en modulation négative. La plus grande partie des pays européens et même du monde émet en modulation négative. La France, le Luxembourg et quelques autres pays émettent en modulation positive.

Les tubes utilisés dans les émetteurs de télévision sont généralement des tétrodes. L'invention peut très bien s'appliquer à d'autres tubes à grille tels que les triodes, les pentodes etc...

Les tubes amplificateurs utilisés comme émetteurs de télévision fonctionnent généralement en classe B. L'invention peut aussi s'appliquer à des tubes amplificateurs fonctionnant en classe AB, B ou C.

Une triode est un tube comportant une cathode émettant des électrons, une anode ou plaque et une seule grille, dite grille de commande, placée entre la cathode et l'anode.

Une tétrode comporte une grille supplémentaire dite grille écran, placée entre la grille de commande et l'anode.

Une pentode comporte une grille de plus que la tétrode, cette grille dite grille d'arrêt étant insérée entre la grille écran et l'anode.

Un émetteur de télévision émet un signal vidéo comprenant notamment la répétition des deux signaux suivants : un signal de synchronisation et un signal vidéo de ligne. La période de répétition de ces deux signaux est d'environ 64 microsecondes dans les systèmes à 625 lignes.

Le signal de synchronisation est une impulsion sensiblement rectangulaire dont la durée est d'environ 4,6 microsecondes. Cette durée est très courte par rapport à la période de répétition. Le signal vidéo de ligne dure le reste de la période de répétition c'est à dire environ 59,4 microsecondes.

Dans le système à modulation négative la puissance maximale de l'émetteur est délivrée pendant le signal de synchronisation. Le niveau maximal du signal vidéo de ligne correspond au noir, le niveau minimal du signal vidéo de ligne correspond au blanc.

Au contraire, en modulation positive, le signal de synchronisation correspond à la puissance minimale de l'émetteur. Le niveau maximal du signal vidéo de ligne correspond au blanc et le niveau minimal au noir.

Dans la suite on ne s'intéressera qu'aux systèmes à modulation négative.

Pour obtenir, en sortie de l'émetteur, un signal de synchronisation de puissance suffisante il faut alimenter l'anode du tube par une tension de polarisation élevée qui est bien supérieure à la tension nécessaire pour obtenir la puissance correspondant au noir.

Cette tension de polarisation ne sert que pendant la durée du signal de synchronisation et elle est inutilement élevée pendant toute la durée du signal vidéo de ligne.

Le rendement du tube est proportionnel au rapport de la tension du signal vidéo émis par le tube sur la tension de polarisation de l'anode. La durée d'émission du signal de ligne étant beaucoup plus longue que la durée d'émission du signal de synchronisation, le rendement global du tube est pratiquement celui du signal vidéo de ligne. Et ce rendement est très faible à cause de la tension de polarisation inutilement élevée.

Le présente invention vise à remédier à cet inconvénient en proposant un tube à grille à rendement amélioré. Elle s'applique à tous les tubes amplificateurs produisant au moins une combinaison d'un premier signal sur une courte durée et d'un second signal sur une durée plus longue, la tension maximale du premier signal étant supérieure à la tension maximale du second signal.

Pour cela on réduit la tension de polarisation d'anode, à un niveau suffisant pour obtenir la tension maximale du second signal.

Mais la tension de polarisation d'anode réduite ne permet plus à priori d'obtenir la tension maximale du premier signal. Le gain du tube chute alors pendant la durée du premier signal ce qui n'est pas souhaitable.

On connait par le brevet JP-A 57-67 381 un amplificateur de puissance produisant une combinaison d'un signal de synchronisation sur une première durée et d'un signal d'image sur une seconde durée plus longue. En vue d'augmenter le rendement de l'amplificateur, on modifie sa tension d'alimentation en fonction du signal d'image ou de synchronisation produit.

Cette modification nécessite un modulateur de puissance coûteux.

Pour remédier à ces inconvénients, on fait évoluer la classe du tube vers la classe A pendant la durée du premier signal en modulant au moins .

La présente invention propose un tube amplificateur à grille tel que défini dans la revendication 1. Par exemple, si le tube comporte une grille écran on peut alimenter sa grille écran par une tension de polarisation modulée. Cette tension comporte alors une impulsion d'amplitude positive dont la durée est celle du premier signal.

On peut aussi alimenter la grille de commande du tube par une tension de polarisation modulée. Cette tension comprend alors une impulsion d'amplitude positive dont la durée est celle du premier signal. On peut aussi alimenter l'anode du tube par une tension de polarisation modulée. Cette tension comprend alors, une impulsion d'amplitude positive dont la durée est celle du premier signal. On peut également combiner deux par deux ou toutes ensembles les tensions de polarisation modulées.

L'invention s'applique notamment aux émetteurs de télévision fonctionnant en modulation négative et le tube amplificateur produit un signal vidéo qui est au moins une combinaison d'un signal de synchronisation de courte durée et d'un signal vidéo de ligne de durée plus longue. Dans cette application, la tension maximale du signal vidéo de ligne correspond à la couleur noire.

L'invention sera mieux comprise et d'autres avantages apparaîtront à la lecture de la description détaillée qui suit et qui est faite en référence aux dessins annexés dans lesquels :

- la figure 1 représente un schéma électrique d'une tétrode montée en amplificateur;
- la figure 2 représente, en fonction du temps, la tension VP d'un signal vidéo et la tension de polarisation d'anode VPO appliquée à une tétrode classique utilisée comme émetteur de télévision ;
- la figure 3 représente, en fonction du temps, les tensions de polarisation VG1,VG2 appliquées respectivement sur la grille de commande et sur la grille écran de la tétrode de la figure 1,
- la figure 4 représente, en fonction du temps la tension VP' d'un signal vidéo et la tension de polarisation d'anode VP1 appliquée à une tétrode selon l'invention, utilisée comme émetteur de télévision ;
- la figure 5 représente, en fonction du temps, les tensions de polarisation VG1', VG2' pouvant être appliquées respectivement sur la grille de commande et sur la grille écran de la tétrode de la figure 4.

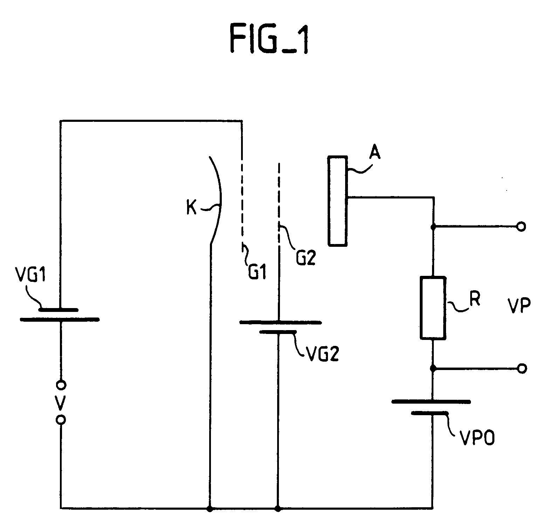

Le schéma d'un tube tétrode classique monté en amplificateur est représenté sur la figure 1. Ce tube comporte une cathode K destinée à émettre des électrons, une grille de commande G1 alimentée par une tension de polarisation VG1, une grille écran G2 alimentée par une tension de polarisation VG2 et une anode A ou plaque alimentée par une tension de polarisation VP0. Par la suite on désignera par la même référence une source de tension et la tension qu'elle produit. On applique à la grille G1 une tension V qui correspond au signal à amplifier. Une résistance R est montée entre l'anode A et la source de tension VPO. Aux bornes de cette résistance apparaît une tension VP qui correspond à la tension V après amplification.

Les tensions de polarisation sont des tensions continues. La tension VG1 est négative par rapport au potentiel de la cathode K.

Lorsque la tétrode est utilisée comme amplificateur dans un émetteur de télévision, elle produit un signal vidéo VP comprenant notamment la répétition des deux signaux suivants : un signal de synchronisation et un signal vidéo de ligne. La période de répétition de ces deux signaux est d'environ 64 microsecondes. Le signal de synchronisation dure 4,6 microsecondes et le signal vidéo de ligne environ 59,4 microsecondes. Le tube produit au moins une combinaison d'un premier signal qui est le signal de synchronisation et d'un second signal qui est le signal vidéo de ligne.

Le signal de synchronisation est constitué par une impulsion sensiblement rectangulaire.

La tension maximale VP max du signal de synchronisation est supérieure à la tension maximale VPN du signal vidéo de ligne. La tension VPN correspond à la couleur noire.

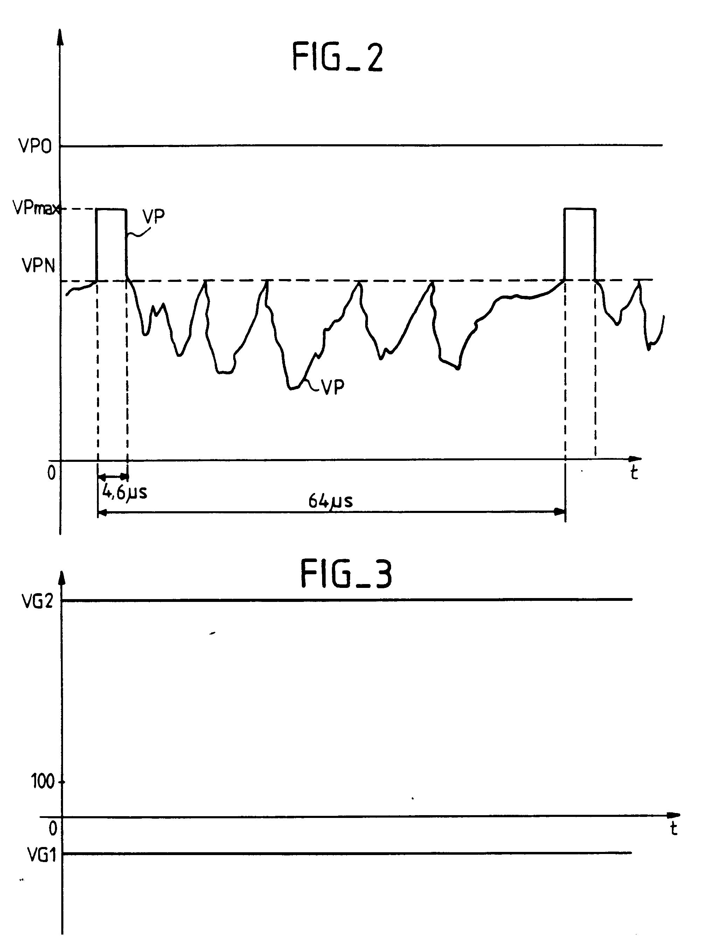

La figure 2 représente en fonction du temps les tensions VPO et VP. Le niveau de la tension VPN du signal vidéo au noir est indiqué. Sur la figure 3, on a représenté les tensions VG1, VG2 . Les deux figures ne sont pas à la même échelle.

La tension VP est telle que le rapport $VP^2/2\,R$ soit égal à la puissance que l'on doit avoir en sortie de l'émetteur.

Pour obtenir cette tension VP, il faut que la tension VPO soit supérieure à VP. En général le rapport VP/VPO est de l'ordre de 0,8.

Dans les systèmes de télévision à modulation négative, le rapport de la tension maximale du signal vidéo de ligne VPN sur la tension du signal de synchronisation est de l'ordre de 0,73.

On obtient :

VPN = 0,58 VPO

Cela signifie que le rapport de la puissance du signal vidéo de ligne au noir sur la puissance du signal de synchronisation est de $(0,73)^2$ c'est à dire de 0,53.

Un tube tétrode utilisé dans un émetteur de télévision fournissant en sortie une puissance maximum de 10 kW fonctionne de façon classique avec des tensions suivantes :

VPO = 5 500 V

VP max = 4 400 V

VPN = 3 200 V

VG1 = - 100 V

VG2 = 600 V

Il faut que le tube fonctionne de façon linéaire même à puissance de sortie élevée. Sinon, les non-linéarités introduisent des distorsions de l'amplitude du signal de sortie et ces non linéarités sont très gênantes surtout pour des signaux vidéo en couleurs.

La courbe de gain en puissance du tube doit être la plus rectiligne possible. Cette courbe représente la puissance du signal de sortie du tube en fonction de la puissance du signal d'entrée du tube. On peut admettre toutefois que cette courbe s'infléchisse de quelques pour cents pour des puissances de sortie supérieures à la puissance correspondant au niveau de noir.

Pour des raisons de meilleure linéarité les tubes utilisés comme émetteurs de télévision fonctionnent en classe B.

Dans cette classe, le rendement du tube est don-

né par :

$$n = (\P/4) \cdot (VP/VPO)$$

Pendant la durée du signal de synchronisation on obtient un rendement n = 63 %.

Pendant la durée du signal vidéo de ligne, au noir, le rendement chute, on a alors n = 45 %.

Comme la durée du signal vidéo de ligne est bien plus longue que la durée du signal de synchronisation, le rendement du tube est pratiquement le rendement pendant la durée du signal vidéo de ligne et ce rendement est très faible.

C'est la tension VPO, inutilement élevée pendant la durée signal vidéo de ligne qui est la cause de la chute du rendement.

La présente invention vise à remédier à cet inconvénient.

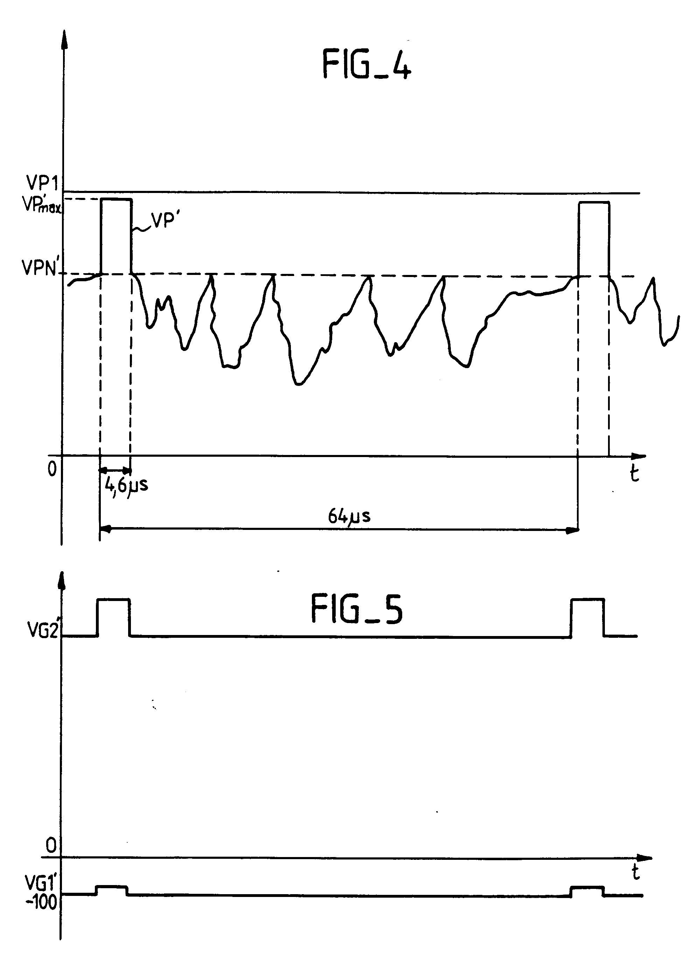

Pour cela on a proposé de réduire, la tension VPO, à un niveau permettant d'obtenir la tension maximale du signal vidéo de ligne mais pas la tension maximale du signal de synchronisation. La tension VPO est choisie pour que le signal vidéo de ligne soit de bonne qualité, c'est à dire que l'on conserve un gain en puissance correct pendant le signal vidéo de ligne. Soit VP1 cette nouvelle tension de polarisation de l'anode. Elle est représentée sur la figure 4.

La tension VP1 est naturellement inférieure à la tension VPO choisie précédemment.

En conséquence, pendant la durée du signal de synchronisation, la puissance obtenue en sortie de l'émetteur est alors insuffisante et l'on observe une chute de gain et un défaut de linéarité du tube. La chute gain peu aller jusqu'à 10 à 12 %, par exemple.

Pour compenser à cette chute de gain, on est amené à faire évoluer la classe du tube vers la classe A, pendant la durée du signal de synchronisation. La figure 4 comporte aussi la tension VP' du signal vidéo que l'on obtient, lorsque l'on utilise une tension VP1 inférieure à VPO et que l'on a fait évoluer la classe du tube vers la classe A, pendant la durée du signal de synchronisation. Le fait d'utiliser une tension VP1 et de faire évoluer la classe du tube pendant la durée du signal de synchronisation permet d'obtenir à la fois la tension maximale VP' max du signal de synchronisation et la tension maximale VPN' du signal vidéo de ligne.

Pour changer la classe d'un tube, il suffit de modifier la tension de polarisation d'au moins une des électrodes du tube.

On peut, par exemple, si l'on travaille avec une tétrode, élever la tension de polarisation VG2 de la grille écran G2, pendant la durée du signal de synchronisation. Cela revient à moduler en impulsion la tension VG2. La tension modulée VG2' est représentée sur la figure 5. Les impulsions ont pour durée la durée du signal de synchronisation, elles seront sensiblement rectangulaires avec des fronts de montée et de descente aussi raides que possible. Leur amplitude sera positive. La tension de polarisation VG1 de la grille de commande G1 n'est pas modifiée.

On peut aussi agir sur la tension de polarisation VG1 de la grille de commande G1 pendant toute la durée du signal de synchronisation. Cela revient à moduler en impulsions la tension VG1. On obtient une tension VG1' représentée sur la figure 5. Les impulsions seront sensiblement rectangulaires avec des fronts de montée et de descente aussi raides que possible. Leur amplitude sera positive. La tension de polarisation de la grille G2 d'écran n'est pas modifiée.

On pourrait aussi élever la tension de polarisation d'anode VP1 pendant la durée du signal de synchronisation. Mais cette solution n'est pas très intéressante car cette variante nécessiterait l'emploi d'un modulateur de puissance.

On peut aussi moduler simultanément deux ou plus des tensions de polarisation.

Pour moduler une tension de polarisation, on utilise un dispositif électronique approprié déclenché par les impulsions du signal de synchronisation.

Dans le cas d'une tétrode, par exemple, on pourrait envisager de faire varier à la fois la tension VG1, et la tension VG2 pendant toute la durée du signal de synchronisation.

Lorsque l'on fait varier les tensions VG1 et/ou VG2, la tension VP1 est réduite en permanence.

Si l'on admet que la tension de polarisation d'anode VP1 a été réduite de 15 % par rapport à la tension VPO, le niveau de la tension du signal vidéo de ligne, au noir, sera :

$$VPN' = 0{,}8 \times 0{,}73\ VPO$$

Le rendement du tube, pendant la durée du signal vidéo de ligne, au noir sera alors :

$$n' = (\P/4)(VPN'/VP1) = 54\ \%$$

L'amélioration du gain obtenu par rapport au fonctionnement classique est d'environ 20 %.

La solution préférée, lorsque l'on travaille avec une tétrode ou un tube à plus de deux grilles est de moduler la tension de polarisation VG2 de la grille écran G2. En effet, la variation de la tension VG2 agit comme un vernier.

Une variation de la tension de polarisation VG1 de la grille de commande a un effet immédiat et brutal. Le réglage est alors délicat.

En effet, une variation dVG1 de la tension VG1 correspond à une variation du courant d'anode et la même variation du courant d'anode correspond à une variation dVG2 de la tension VG2 telle que :

$$dVG2 = k \cdot dVG1$$

k est le coefficient d'amplification du tube mesuré en triode et ce coefficient est supérieur à quelques unités.

Une tétrode dont la puissance maximale est de 10 kW, fonctionnant avec un rendement amélioré selon l'invention, sera alimentée avec les tensions de polarisation suivantes :

VP1 = 4 500 V en permanence.

Lorsque l'on module la tension de polarisation de la grille écran G2 :

VG2' = 700 V pendant la durée du signal de synchronisation

VG2' = 600 V pendant la durée du signal vidéo de ligne

VG1 = -100 V en permanence.

Lorsque l'on module la tension de polarisation de la grille de commande G1 :

VC1' = -90 V pendant la durée du signal de synchronisation

VC1' = -100 V pendant la durée du signal vidéo de ligne

VC2 = 600 V en permanence.

L'invention n'est pas limitée aux tubes amplificateurs utilisés dans les émetteurs de télévision.

Elle peut s'appliquer à tout tube amplificateur fonctionnant en classe AB, B ou C, produisant au moins une combinaison d'un premier signal sur une courte durée et d'un second signal sur une durée plus longue, la tension maximale du premier signal étant supérieure à la tension maximale du second signal.

## Revendications

1. Tube amplificateur à grille comportant une anode (A) alimentée par une tension d'alimentation (VP1) et une ou plusieurs grilles (G1, G2) alimentées par une tension de polarisation (VG1, VG2), le tube produisant avec un gain sensiblement constant, au moins une combinaison d'un premier signal sur une courte durée et d'un second signal sur une durée plus longue, la tension maximale du premier signal étant supérieure à la tension maximale du second signal, caractérisé en ce que la tension d'alimentation d'anode (VP1) est réglée à un niveau permettant au tube de fonctionner en classe B,AB ou C et de produire la tension maximale (VPN') du second signal mais pas celle du premier signal et en ce qu'il comprend des moyens pour moduler au moins une des tensions de polarisation (VG1', VG2') de manière à ce que sa classe de fonctionnement évolue vers la classe A pendant la durée du premier du premier signal et qu'il produise la tension maximale du premier signal.

2. Tube amplificateur selon la revendication 1 comportant une grille de commande (G1) caractérisé en ce que la tension de polarisation modulée est la tension de polarisation de la grille de commande, cette tension de polarisation comportant une impulsion d'amplitude positive pendant toute la durée du premier signal.

3. Tube amplificateur selon l'une des revendications 1 ou 2, comportant une grille écran (G2) caractérisé en ce que la tension de polarisation modulée est la tension de polarisation (VG2') de la grille écran, cette tension de polarisation comportant une impulsion d'amplitude positive pendant toute la durée du premier signal.

4. Tube amplificateur selon l'une des revendications 1 à 3, caractérisé en ce que la tension d'alimentation (VP1) d'anode (A) est aussi modulée et comporte une impulsion d'amplitude positive pendant toute la durée du premier signal.

5. Tube amplificateur selon l'une des revendications 1 à 4 caractérisé en ce qu'il est utilisé comme émetteur de télévision fonctionnant en modulation négative, le premier signal étant un signal de synchronisation et le second signal un signal vidéo de ligne.

6. Tube amplificateur selon la revendication 5 caractérisé en ce que la tension maximale du signal vidéo de ligne correspond à la couleur noire.

## Patentansprüche

1. Gitter-Verstärkerröhre mit einer Anode (A), die mit einer Vorspannung (VP1) gespeist wird, und mit einem oder mehreren Gittern (G1, G2), die mit je einer Vorspannung (VG1, VG2) gespeist werden, wobei die Röhre mit im wesentlichen konstantem Verstärkungsgrad mindestens eine Kombination eines ersten Signals kurzer Dauer und eines zweiten Signals längerer Dauer erzeugt, wobei die Maximalspannung des ersten Signals größer als die Maximalspannung des zweiten Signals ist, dadurch gekennzeichnet, daß die Anodenvorspannung (VP1) auf einen Wert eingestellt wird, der es der Röhre erlaubt, in Klasse B, AB oder C betrieben zu werden und die Maximalspannung (VPN') des zweiten Signals zu erzeugen, nicht aber die Maximalspannung des ersten Signals, und daß Mittel zur Modulation mindestens einer der Gittervorspannungen (VG1', VG2') vorgesehen sind,so daß die Betriebsklasse sich während der Dauer des ersten Signals in Richtung zur Klasse A verschiebt und die Röhre die Maximalspannung des ersten Signals erzeugt.

2. Verstärkerröhre nach Anspruch 1 mit einem Steuergitter (G1), dadurch gekennzeichnet, daß die modulierte Vorspannung die Vorspannung des Steuergitters ist und einen Impuls einer positiven Amplitude während der ganzen Dauer des ersten Signals enthält.

3. Verstärkerröhre nach einem der Ansprüche 1 oder 2 mit einem Schirmgitter (G2), dadurch gekennzeichnet, daß die modulierte Vorspannung die Vorspannung (VG2') des Schirmgitter ist und einen Impuls positiver Amplitude während der ganzen Dauer des ersten Signals enthält.

4. Verstärkerröhre nach einem der Ansprüche 1 bis 3, dadurch gekennzeichnet, daß die Vorspannung (VP1) der Anode (A) ebenfalls moduliert wird und einen Impuls einer positiven Amplitude während der ganzen Dauer des ersten Signals enthält.

5. Verstärkerröhre nach einem der Ansprüche 1 bis 4, dadurch gekennzeichnet, daß sie als Fernsehsender für Fernsehsignale mit negativer Modulation verwendet wird, wobei das erste Signal ein Synchronisationssignal und das zweite Signal ein Zeilenvideosignal ist.

6. Verstärkerröhre nach Anspruch 5, dadurch gekennzeichnet, daß die Maximalspannung des Zeilenvideosignals dem Schwarzwert entspricht.

**Claims**

1. Amplifier valve with a grid, including an anode (A) supplied by a supply voltage (VP1) and one or more grids (G1, G2) supplied by a bias voltage (VG1, VG2), the valve producing, with a substantially constant gain, at least one combination of a first signal over a short duration and of a second signal over a longer duration, the maximum voltage of the first signal being higher than the maximum voltage of the second signal, characterized in that the anode supply voltage (VP1) is set at a level allowing the valve to operate in class B, AB or C, and to produce the maximum voltage (VPN') of the second signal but not that of the first signal and in that it comprises means for modulating at least one of the bias voltages (VG1', VG2') in such a way that its class of operation changes towards class A throughout the duration of the first signal and that it produces the maximum voltage of the first signal.

2. Amplifier valve according to Claim 1, including a control grid (G1), characterized in that the modulated bias voltage is the bias voltage of the control grid, this bias voltage including a positive amplitude pulse throughout the entire duration of the first signal.

3. Amplifier valve according to one of Claims 1 or 2, including a screen grid (G2), characterized in that the modulated bias voltage is the bias voltage (VG2') of the screen grid, this bias voltage including a positive amplitude pulse throughout the entire duration of the first signal.

4. Amplifier valve according to one of Claims 1 to 3, characterized in that the anode supply voltage (VP1) is also modulated and includes a positive amplitude pulse throughout the entire duration of the first signal.

5. Amplifier valve according to one of Claims 1 to 4, characterized in that it is used as a television transmitter operating in negative modulation, the first signal being a synchronization signal and the second signal a video line signal.

6. Amplifier valve according to Claim 5, characterized in that the maximum voltage of the video line signal corresponds to the colour black.

# FIG_1

## FIG_2

## FIG_3

# FIG_4

VP1
VP'max
VP'
VPN'
0
4,6µs
64µs
t

# FIG_5

VG2'
0
t
VG1'
-100